# EUROPEAN PATENT APPLICATION

(11) **EP 4 782 861 A1**
(43) Date of publication of application: **29.07.2026**
(21) Application number: 25153302.2
(22) Date of filing: 22.01.2025
(51) Int. Cl.: G01R 33/3815

(54) **SHAPE OPTIMIZED COILS MADE OF HIGH TEMPERATURE SUPERCONDUCTING (HTS) DOUBLE PANCAKES FOR MRI MAGNETS**

(71) Applicant: Koninklijke Philips N.V., 5656 AE Eindhoven (NL)
(72) Inventor: VAN LANEN, Ezra Petrus Antonius, Eindhoven (NL); KIM, Kwang Lok, Eindhoven (NL); CARR, William Gerard, Eindhoven (NL); MOKHNATYUK, Viktor, Eindhoven (NL)
(74) Representative: Philips Intellectual Property & Standards

(57) **Abstract**

A magnet (**1**) for a magnetic resonance imaging (MRI) device (**2**) includes a plurality of annular magnet coils (**12, 14**), wherein each annular magnet coil includes a stack of coaxial double-pancake coils (**40**) including a superconducting material. The stack of coaxial double-pancake coils of each annular magnet coil has a convex outer surface in a virtual plane (**P**) containing a common axis (**CA**) of the coaxial double-pancake coils.

## Description

The following relates generally to the magnetic resonance imaging (MRI) arts, magnet arts, MRI superconductor arts, and related arts.

### BACKGROUND

Coils of MRI magnets are built with one or more low-temperature superconducting (LTS) wires, which requires a cooling system that can keep its coils below 5K. The power consumption by the cryocooler to keep the magnet at this temperature takes up a large fraction of the operational cost of an MRI scanner. A magnet made with high temperature superconducting (HTS) wire can mitigate this, but HTS wire is typically available in single-length pieces, and is expensive compared to LTS wire, so HTS wire has so far been an uneconomical option.

One type of HTS wire is made in the form of tape such as REBCO or Bi-2223. These tapes become superconductive below 80K, and their critical current (current carrying capacity) sharply increases as the temperature is further reduced. This gives a magnet designer much more flexibility in finding an optimum for the total cost of ownership of the system. For example, designing a magnet at a low temperature reduces the material cost, because less of the expensive superconducting wire is utilized, but requires a higher operational cost to keep it at that temperature.

The following discloses certain improvements to overcome these problems and others.

### SUMMARY

In some nonlimiting illustrative embodiments, a magnet for an MRI device includes a plurality of annular magnet coils, wherein each annular magnet coil includes a stack of coaxial double-pancake coils including a superconducting material. The stack of coaxial double-pancake coils of each annular magnet coil has a convex outer surface in a virtual plane containing a common axis of the coaxial double-pancake coils.

In some nonlimiting illustrative embodiments, a magnet for a MRI device includes a first set of annular coils including a superconducting material, the first set of annular coils being electrically connected together and arranged with a common coil axis to form a first annular magnet coil. A second set of annular coils includes the superconducting material, the second set of annular coils being electrically connected together and arranged with the common coil axis to form a second annular magnet coil. The first annular magnet coil has an outer annular surface which is convex in a virtual plane containing the common coil axis; and the second annular magnet coil has an outer annular surface which is convex in the virtual plane containing the common coil axis.

In some nonlimiting illustrative embodiments, a magnet for an MRI device includes a plurality of annular magnet coils wherein each annular magnet coil includes a stack of coaxial coils including a superconducting material. A cross-section of the stack of coaxial coils of each annular magnet coil has a convex outer surface.

One advantage resides in providing an improved magnet for an MRI device with a HTS coil with a double pancake design.

Another advantage resides in providing a magnet for an MRI device with a HTS coil with improved magnetic field uniformity in the bore of the magnet.

Another advantage resides in providing a magnet for an MRI device with a HTS coil having lower manufacturing cost.

Another advantage resides in providing a magnet for an MRI device having a lower manufacturing cost based on an efficient use and shape of material of a HTS coil.

Another advantage resides in providing a magnet for an MRI device with a HTS coil having shapes wound to different heights to optimize an amount of conductor in the HTS coil.

A given embodiment may provide none, one, two, more, or all of the foregoing advantages, and/or may provide other advantages as will become apparent to one of ordinary skill in the art upon reading and understanding the present disclosure.

### BRIEF DESCRIPTION OF THE DRAWINGS

The example embodiments are best understood from the following detailed description when read with the accompanying drawing Figures. It is emphasized that the various features are not necessarily drawn to scale. In fact, the dimensions may be arbitrarily increased or decreased for clarity of discussion. Wherever applicable and practical, like reference numerals refer to like elements.
FIG. 1 diagrammatically illustrates a sectional view of a portion of a magnetic resonance imaging (MRI) device according to one aspect.
FIG. 2 schematically illustrates a perspective view of a double-pancake coil wound with tape conductor of the magnet of the MRI device of FIG. 1.
FIG. 3 schematically illustrates a perspective view of a magnet of the MRI device of FIG. 1.
FIG. 4 illustrates an arrangement of coils of the MRI device of FIG. 1.
FIG. 5 illustrates a background magnetic field direction on a HTS tape surface and the magnetic field lines around a cross-section of a coil of the MRI device of FIG. 1.
FIG. 6 illustrates a ring disposed around a coil of the MRI device of FIG. 1.

### DETAILED DESCRIPTION

The following discloses a design for a magnet for MRI scanners using high temperature superconducting wire (i.e., tape). The coils for the magnet are built with multiple stacks of double pancake coils. Each double pancake coil is a coil with only two turns, but a variable number of layers. The number of layers may be different in each double pancake coil to ensure an optimal magnetic field uniformity in the bore of the magnet.

The coils are suitably made with stacks of double-pancakes, each wound from a single length of tape, and with the double pancake coils electrically connected with low-resistance joints. Numerical optimization shows that ideal solutions for maximizing magnetic field uniformity have concave or convex shaped coils.

The following discloses a coil arrangement that approximates these concave or convex coil shapes with stacks of pancakes, each of which is wound to a different height (i.e., outer or inner diameter, depending on the coil design). In some embodiments, each annular magnet coil comprises a stack of coaxial double-pancake coils comprising the HTS tape (or other chosen superconducting material), and the stack of coaxial double-pancake coils of the annular magnet coil has a convex outer surface in a virtual plane containing a common axis of the coaxial double-pancake coils of the stack. The critical current of the HTS tape decreases as the background field increases. This effect is much more pronounced when the magnetic field is perpendicular to the face of the HTS tape than when the magnetic field is in-plane. The magnetic field generated by a coil in this magnet design has its largest perpendicular field at its edges, whereas the magnetic field is mostly in-plane with the superconducting tape elsewhere in the coils. Based on this insight, in some embodiments the annular magnet coil constructed as a stack of coaxial double-pancake coils uses expensive, high-quality HTS tape for the outer double-pancake coils located at the periphery of the annular magnet coil, and uses a lower-cost, lower quality HTS tape for the double-pancake coils located in the center of the annular magnet coil. (By "lower quality," it is here meant that the HTS tape may have a lower critical current for superconductivity compared with the "higher quality" HTS tape of the peripheral double-pancake coils.)

The magnet can be energized and controlled in the same way as conventional, low-temperature superconducting MRI magnets. In some embodiments, the stack of double-pancake coils making up the annular magnet coil are joined by non-superconducting splices between the double-pancake coils, and these splices have a finite resistance. If left to run in persistent mode, the resistive splices cause the superconducting current in the magnet to decay, so that the magnet loses its magnetic field in a matter of days or weeks, as opposed to years. This persistence problem can be overcome by installing a permanent power supply, which automatically ramps the magnet back to nominal field whenever needed.

The disclosed MRI magnet makes more efficient use of the available lengths of superconducting tape, which reduces scrap or recycling cost. The magnet is built up of stacks of smaller coils, with the inner and/or outer diameters of the constituent coils designed to enable the magnet to meet magnetic field uniformity requirements.

The required cooling power can be greatly reduced when HTS technology is used instead of LTS, which reduces the energy costs for operating the magnet and makes the MRI devices ecologically more sustainable. The method of building such a magnet described herein has the additional benefit of reducing the material cost.

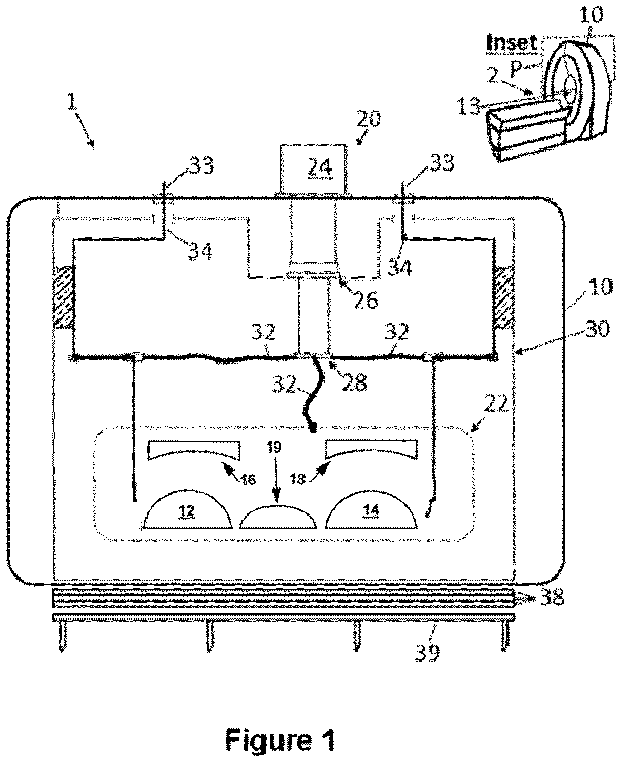

With reference now to FIG. 1, a sectional view is shown of a portion of a magnetic resonance imaging (MRI) device **2** is diagrammatically shown. The Inset of FIG. 1 illustrates the section plane **P** through a portion of a cooling vessel or housing **10** of the MRI device **2,** which contains two or more (diagrammatically illustrated five) superconducting windings (i.e., coils, or more specifically, annular coils) **12, 14, 16, 18, 19** of a main magnet **1** of the MRI device **2.** When energized by an electric current flowing therethrough, the superconducting coils **12, 14, 16, 18, 19** produce a static (B0) magnetic field in a bore **13** (see Inset) of the MRI device **2.** As seen in the Inset, the cooling vessel **10** is generally cylindrical and surrounds the bore **13.** The static (B0) magnetic field produced by the energized superconducting coils **12, 14, 16, 18, 19** produces the B0 field typically oriented parallel (or antiparallel) with the axis of the bore **13.** The nominal (i.e., design-basis) strength of the static (B0) magnetic field may, for example, be in a range of 0.2 Tesla to 7 Tesla depending on the MRI device design, although B0 field strengths above or below this range are also contemplated.

The housing **10** is (or includes) a vacuum container **10** configured to thermally isolate the superconducting coils **12, 14, 16, 18, 19** so the superconducting coils **12, 14, 16, 18, 19** are maintained below the superconducting transition temperature (at the operational electric current) of the superconducting material making up the superconducting coils **12, 14, 16, 18, 19.** The cooling vessel **10** is a vacuum vessel or container **10.** Outside the vacuum container **10** is typically air at room temperature (300K). Inside the vacuum container **10** is a vacuum (said another way, during operation of the magnet the vacuum container **10** is evacuated). A cryocooler (e.g., a cold head) **20** is operative to cool a diagrammatically indicated cryogenic structure **22** that includes the superconducting coils **12, 14, 16, 18, 19.** Although not shown, the cryogenic structure **22** typically includes additional components, such as a former of copper, copper alloy, or another metal or other material on which the superconducting coils **12, 14, 16, 18, 19** are disposed, and endplates that serve as support connection points. The illustrative cryocooler 20 is a two-stage refrigerator with a compressor motor **24** that cyclically compresses and decompresses gas helium or another suitable working fluid to cool a first stage **26** of the cryocooler **20** to a first stage temperature that is below room temperature, and to further cool a second stage **28** of the cryocooler **20** to a lower second stage temperature that is below the superconducting transition temperature (at the operational electric current) of the superconducting material making up the superconducting coils **12, 14, 16, 18, 19.** The first stage **26** of the cryocooler **20** is thermally connected to cool a radiation shield **30** disposed inside the vacuum container **10** to about the first stage temperature. During operation of the magnet, the thusly cooled radiation shield **30** reduces radiative thermal losses from the cryogenic structure **22.** The second stage **28** of the cryocooler **20** is thermally connected with the cryogenic structure **22** by one or more thermal links **32.**

The magnet coils **12, 14, 16, 18, 19** have terminal connections **33** located outside of the vacuum container **10,** which are at room temperature (e.g., ~300K). An electrical conductor **34** extends from each terminal connection **33** into the vacuum container **10** through a vacuum feedthrough **42.** The terminal connections **33** and conductors **34** are typically made of copper or a copper alloy or the like and are not superconducting during operation of the magnet. To charge the superconducting coils **12** with an electric current for generating the static B0 magnetic field, a magnet power supply (not shown) is connected with the terminal connections **33** to deliver electric current to the superconducting coils **12, 14, 16, 18, 19** via the electrical conductors **34.** In driven mode magnet operation, connection of the magnet power supply with the superconducting coils **12, 14, 16, 18, 19** is maintained during operation of the magnet, to compensate for resistive power losses at non-superconducting joints of the magnet circuit. Alternatively, it is contemplated to operate the magnet (at least part-time) in a persistent mode by disconnecting the power supply from the magnet coils **12, 14, 16, 18, 19** using solenoid driven lead contactors or the like (not shown).

The magnet **1** of the MRI device **2** may optionally include other components (not shown), such as a superconducting connection across the leads of the interconnected coils **12, 14, 16, 18, 19** with a persistent current switch (to support magnet operation in persistence mode), and/or a quench protection circuit to rapidly dissipate the electrical current in the coils **12, 14, 16, 18, 19** in the event of a quench.

As further shown in FIG. 1, the MRI device **2** may include various ancillary components, such as an illustrative set of magnetic field gradient coils **38** for encoding NMR induced in a patient or other MRI imaging subject disposed in the bore **13,** and/or a whole-body radio frequency (RF) coil **39** for exciting the NMR in the patient or other subject. The RF coil **39** may, for example, be a birdcage coil or a transverse electromagnetic (TEM) coil, as two nonlimiting illustrative examples, and may optionally also include an RF shield (not shown). The gradient coils **38** and optional RF coil **39** are suitably arranged concentrically in the bore **13.**

With continuing reference to FIG. 1, the annular magnet coils **12, 14, 16, 18, 19** includes a first coil **12,** a second coil **14,** a third coil **16,** a fourth coil **18,** and a fifth coil **19.** More generally, there may be two coils, three coils, four coils, or more. The coils **12, 14, 16, 18, 19** each comprise a superconductor (i.e., a superconducting material that becomes superconducting at below its critical temperature) that has a superconducting critical temperature. The superconductor can be a high temperature superconductor (HTS). In some nonlimiting illustrative examples, the superconductor of each of the coils **12, 14, 16, 18, 19** is a rare earth barium copper oxide (REBCO) superconducting material or a bismuth strontium calcium copper oxide (BSCCO) superconducting material (i.e., Bi-2223). In another example, the superconducting material can be magnesium diboride (MgB₂), for example in the form of a coil of MgB₂ wire. Other superconducting materials are also contemplated as the superconductor. In some nonlimiting illustrative embodiments, the critical temperature of the superconductor is higher than 4K, enabling use without immersive liquid helium cooling.

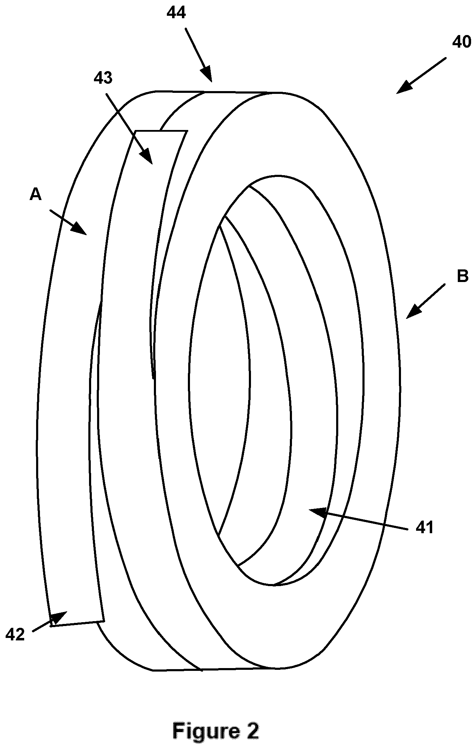

With continuing reference to FIG. 1 and further reference now to FIG. 2, an example of a double pancake coil **40** is shown. As will be described, each of the coils **12, 14, 16, 18, 19** is constructed as a stack of such pancake coils having (in general) different inner or outer diameters. As diagrammatically shown in FIG. 2, the double pancake coil **40** includes a first pancake coil **A** formed as a winding of HTS tape winding inward from a larger outer diameter to a smaller inner diameter, and a second pancake coil **B** wound outward from the smaller inner diameter to the larger outer diameter. At the inner diameter, a portion of HTS tape **41** connects the two pancake coils **A** and **B** to form the interconnected double pancake coil **40.** By this arrangement, the double pancake coil **40** has both of its terminals (i.e., HTS tape ends) **42** and **43** exposed at the outer diameter of the double pancake coil **40,** which simplifies electrical series interconnection of two or more double-pancake coils.

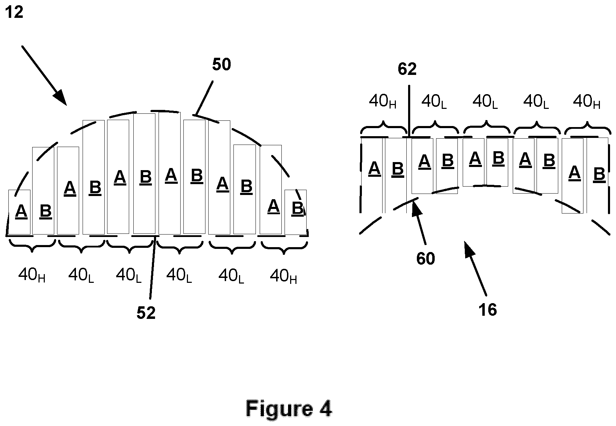

Each coil **12, 14, 16, 18, 19** comprises stack of coaxial double-pancake coils **40** comprising the superconducting material (e.g., see FIG. 4). The double pancake coils **40** of each coil **12, 14, 16, 18, 19** can be electrically connected to each other with low-resistance joints (not shown). In general, the end **43** of the first double pancake coil **40** of the stack is electrically connected with the end **42** of the next double pancake coil **40** in the stack, and so forth, so as to connect the double pancake coils electrically in series. As previously noted, the double pancake coil **40** has both of its terminals (i.e., HTS tape ends) **42** and **43** exposed at the outer diameter of the double pancake coil **40,** which simplifies electrical series interconnection of constituent pancake coils **A** and **B** of the stack; however, it also contemplated to employ a stack of pancake coils that are not configured as double pancakes (e.g., in which every pancake coil is wound outward from the smaller inner diameter to the larger outer diameter; or, alternatively, wound inward from the larger outer diameter to the smaller inner diameter).

FIG. 2 also shows that the double pancake coil **40** includes an insulator **44** disposed between constituent pancake coils **A** and **B** of the stack. The insulator **44** can be a structural sheet configured to take electromagnetic loading, which mostly will be in radial direction trying to enlarge diameter of the coil(s) **12, 14, 16, 18, 19.** HTS materials can be sensitive to mechanical stresses and, without the insulator **44** as a reinforcement, can fail. The insulator **44** can be made from a non-metal (e.g., garolite) if any mechanical load is not too high or has a metal core for taking bigger loads.

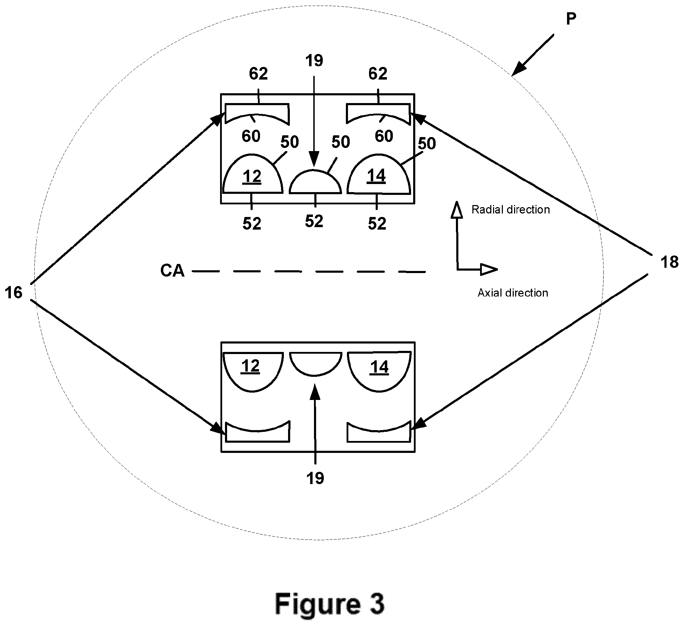

FIG. 1 depicts a sectional view of an upper half of the annular vacuum container **10,** and hence also a sectional view of the upper halves of the coils **12, 14, 16, 18, 19.** With continuing reference to FIG. 1 and further reference now to FIG. 3, each coil **12, 14, 16, 18, 19** is an annular magnet coil. FIG. 3 shows a full sectional view of both upper and lower halves of the annular vacuum container **10,** of the coils **12, 14, 16, 18, 19.** The structure is rotationally symmetric about a central axis **CA,** which may in some embodiments coincide with the central axis of the bore **13** (see Inset of FIG. 1), although this is not required. The central axis **CA** is along the axial direction indicated in FIG. 3; the radial direction is transverse to the axial direction as further indicated. Each pancake coil **40** making up the coils **12, 14, 16, 18, 19** is also rotationally symmetric about the central axis **CA.** As shown in FIG. 3, the annular coils **12, 14, 16, 18, 19** are electrically connected together and arranged with a first common coil axis **CA** (shown in FIG. 3 with a dashed line). Thus, the constituent double-pancake coils making up the coils **12, 14, 16, 18, 19** also have the common coil axis **CA.**

With further reference to FIG. 4, in an illustrative example, two or more (illustrative six) double pancake coils **40_{H}** and **40_{L}** are stacked to form a (first) annular magnet coil **12.** The annular magnet coil **12** has an outer annular surface **50** which is convex in a virtual plane **P** (shown in FIG. 3 with a dashed circle) containing the common coil axis **CA.** The annular magnet coil **12** has an inner annular surface **52** which is planar (i.e., flat) in the virtual plane **P** containing the common coil axis **CA.** The convexity in the plane **P** of the outer annular surface **50** is formed by varying the outer diameters of the double pancake coils **40_{H}** and **40_{L}**, and in the illustrative example by further varying the outer diameters of the constituent pancake coils **A** and **B** within the double pancake coils. As there are a finite number of double pancake coils **40_{H}** and **40_{L}** making up the annular magnet coil **12,** the convex surface **50** in the virtual plane **P** is discretized. In this nonlimiting illustrative example, the convex surface **50** is discretized into twelve portions, corresponding to the six double-pancake coils **40_{H}** and **40_{L}** times two constituent pancake coils **A** and **B** making up each double-pancake coil **40_{H}** or **40_{L}**.

As further shown in FIG. 4, the constituent pancake coils **A** and **B** within the double pancake coils **40_{H}** and **40_{L}** can have different heights. Preferably, each double pancake coil **40_{H}** and **40_{L}** have the same height (as with the annular magnet coil **12**). The **A** and **B** sides of the double pancake coils **40_{H}** and **40_{L}** can have different heights, or they can have the same heights in-between the double pancake coils **40_{H}** and **40_{L}** for sides that come to contact with each other. When each double pancake coils **40_{H}** and **40_{L}** have different heights (as with the annular magnet coil **16**), it can be difficult to electrically connect the double pancake coils **40_{H}** and **40_{L}**. Each double pancake coil **40_{H}** and **40_{L}** can be connected to a neighboring double pancake coil **40_{H}** and **40_{L}** by low-resistive (but still non-superconductive) joints, which necessitates the need of the magnet **1** as a driven magnet.

Referring back to FIG. 3, although not shown in detail as in FIG. 4 it is to be understood that the annular magnet coils **14** and **19** are constructed similarly to the construction of the annular magnet coil **12** shown in FIG. 4, and thus similarly each coil **12, 14,** and **19** has an outer surface **50** which is convex in the virtual plane **P.** (However, the convexity, i.e., detailed convex curvature, of the outer surfaces **50** of the respective annular magnet coils **12, 14,** and **19** may in general be different). The illustrative annular magnet coils **12, 14,** and **19** also each have the inner surface **52** that is planar. Numerical optimization shows that ideal solutions for maximizing magnetic field uniformity have convex shaped magnet coils - hence, the outer surfaces **50** of the annular magnet coils **12, 14,** and **19** which are convex in the virtual plane **P** improves magnetic field uniformity.

The two annular coils **16** and **18** are shield coils, which are also constructed as stacks of double pancake coils. FIG. 4 shows an example of shield coil **16** constructed as two or more (illustrative five) double pancake coils **40_{H}** and **40_{L}** which are stacked to form a (second) annular magnet coil **16.** The shield coil **16** has an inner annular surface **60** which is concave in the illustrated virtual plane **P** containing the common coil axis **CA.** The shield coil **16** has an outer annular surface **62** which is planar (i.e., flat) in the virtual plane **P** containing the common coil axis **CA.** The concavity in the plane **P** of the inner annular surface **60** is formed by varying the inner diameters of the double pancake coils **40_{H}** and **40_{L}**, and in the illustrative example by further varying the inner diameters of the constituent pancake coils **A** and **B** within the double pancake coils. As there are a finite number of double pancake coils **40_{H}** and **40_{L}** making up the shield coil **16,** the concave surface **60** in the virtual plane **P** is discretized. In this nonlimiting illustrative example, the concave surface **60** is discretized into ten portions, corresponding to the five double-pancake coils **40_{H}** and **40_{L}** times two constituent pancake coils **A** and **B** making up each double-pancake coil **40_{H}** or **40_{L}**. Referring back to FIG. 3, although not shown in detail as in FIG. 4 it is to be understood that the annular shield coil **18** is constructed similarly to the construction of the annular shield coil **16** shown in FIG. 4, and thus each shield coil **16** and **18** has an inner surface **60** which is concave in the virtual plane **P.** (However, the concavity, i.e., detailed concave curvature, of the inner surfaces **60** of the respective shield coils may in general be different). The illustrative annular shield coils **16** and **18** also each have the outer surface **62** that is planar. As previously noted, numerical optimization shows that ideal solutions for maximizing magnetic field uniformity have shield coils with concave shaped inner surfaces - hence, the inner surfaces **60** of the shield coils **16** and **18** which are concave in the virtual plane **P** improves magnetic field uniformity.

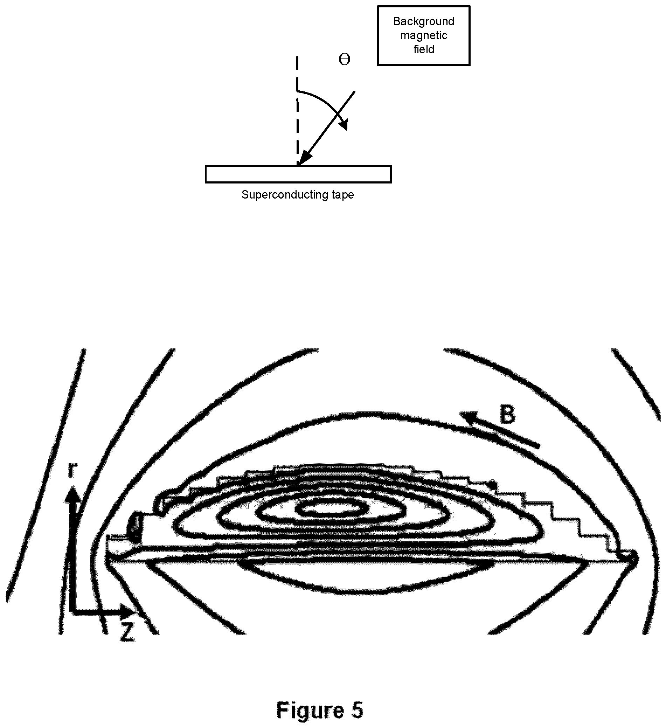

With particular reference to FIG. 4, each of the respective illustrative magnet and shield coils **12** and **16** includes outer double pancake coils **40_{H}** having a first superconducting capacity and at least one inner annular coil **40_{L}** disposed between the outer annular coils **40_{H}** having a second superconducting capacity that is lower than the first superconducting capacity. This is an optional feature, which can reduce magnet cost while maintaining current-carrying capacity of the coils **12** and **16** (and similarly of coils **14, 18,** and **19** if they have a similar stack of outer "high quality" double pancake coils **40_{H}** sandwiching one or more inner "lower quality" double pancake coils **40_{L}**. A critical current (i.e., superconducting capacity) of the HTS tape decreases as a background magnetic field increases. This effect is much more pronounced when the magnetic field is perpendicular to the face of the tape than when the magnetic field is in-plane. The magnetic field generated by an annular coil **12** or **16** in the magnet 1 has its largest perpendicular field at its edges, whereas the magnetic field is mostly in-plane with the superconducting tape within the coils as diagrammatically shown in FIG. 5. Most of the magnetic field lines are close to 90 degrees. This allows the designer to limit the use of expensive, high-quality HTS tape to the "high quality" double pancake coils **40_{H}** at the edges of the coil, and use a cheaper, "lower quality" HTS tape in the center double pancake coils **40_{L}**.

Numerical optimization algorithms can be used to find the locations of current density in space to meet the uniformity requirements. Such algorithms show that ideal solutions have concave or convex shaped coils **12, 14, 16, 18, 19,** e.g., including the convex outer surfaces **50** for the magnet coils **12, 14, 19** and concave inner surfaces **60** for the shield coils **16,18.** The disclosed magnet **1** approximates these convex and concave shapes of the coils **12, 14, 16, 18, 19** with stacks of pancakes, each of which is wound to a different inner or outer diameter as appropriate for the desired concave or convex inner or outer surface.

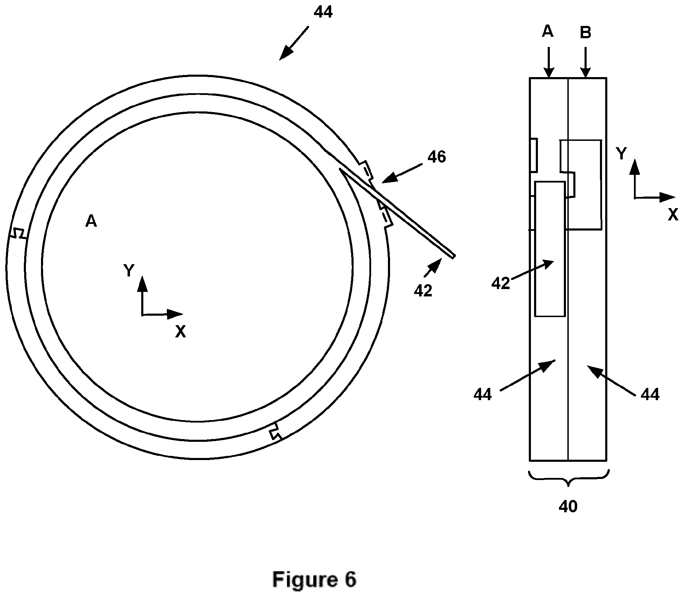

FIG. 6 shows that in some nonlimiting illustrative embodiments, each pancake coil **A** or **B** of each double pancake coil **40** can include a retainer ring **44** disposed around and retaining the wound coil of HTS tape conductor. The left side of FIG. 6 shows a view along the axial direction of the pancake coil **A** retained by the retainer ring **44,** while the right side of FIG. 6 shows a view transverse to the axial direction of the two pancake coils **A** and **B** each retained by a retainer ring **44** and assembled in the double pancake arrangement. The retainer ring **44** can include a clip **46** to secure an end **42** (for pancake coil **A,** as shown) or an end **B** (for pancake coil **B**) of the HTS tape of the pancake coil. The retainer ring **44** may be, for example, a metal ring or ring segment. The retainer ring **44** advantageously applies an inward retention force against the wound HTS tape of the pancake coil, and hence can be used to maintain the shape of the coils when they experience Lorentz forces.

The present disclosure, through one or more of its various aspects, embodiments and/or specific features or sub-components, is thus intended to bring out one or more of the advantages as specifically noted below. For purposes of explanation and not limitation, example embodiments disclosing specific details are set forth in order to provide a thorough understanding of an embodiment according to the present teachings. However, other embodiments consistent with the present disclosure that depart from specific details disclosed herein remain within the scope of the appended claims. Moreover, descriptions of well-known apparatuses and methods may be omitted so as to not obscure the description of the example embodiments. Such methods and apparatuses are within the scope of the present disclosure.

## Claims

1. A magnet (**1**) for a magnetic resonance imaging (MRI) device (**2**), the magnet comprising:
a plurality of annular magnet coils (**12, 14**), wherein each annular magnet coil comprises a stack of coaxial double-pancake coils (**40**) comprising a superconducting material;
wherein the stack of coaxial double-pancake coils of each annular magnet coil has a convex outer surface in a virtual plane (**P**) containing a common axis (**CA**) of the coaxial double-pancake coils.

2. The magnet (**1**) of claim 1, wherein the stack of double-pancake coils (**40**) of each annular magnet coil (**12, 14**) has a flat or concave inner surface in the virtual plane (**P**) containing the common axis (**CA**) of the coaxial double-pancake coils.

3. The magnet (**1**) of either one of claims 1 and 2, further comprising:
a plurality of annular shield coils (**12, 14**), wherein each annular shield coil comprises a stack of coaxial double-pancake coils (**40**) comprising the superconducting material;
wherein the stack of coaxial double-pancake coils of each annular shield coil has a concave inner surface in the virtual plane (**P**) containing the common axis (**CA**) of the coaxial double-pancake coils of the annular shield coil.

4. The magnet (**1**) of claim 3, wherein each double-pancake coil (**40, 41, 42**) comprises one or more loops of tape conductor comprising the superconducting material.

5. The magnet (**1**) of claim **4**, wherein each double-pancake coil (**40, 41, 42**) further comprises a retainer ring (**44**) disposed around and retaining the one or more loops of tape conductor.

6. The magnet (**1**) of any one of claims 3-5, wherein each double-pancake coil (**40**, **41**, **42**) comprises an insulator (**44**) disposed between adjacent double pancake coils (**40**).

7. The magnet (**1**) of any one of claims 1-6, wherein the stack of coaxial double-pancake coils (**40, 41, 42**) of each annular magnet coil (**12, 14**) includes:
outer double-pancake coils (**40_{H}**) on an outside of the stack; and
at least one inner double-pancake coil (**40_{L}**) on an inside of the stack;
wherein a superconducting capacity of the outer double-pancake coils is higher than a superconducting capacity of the at least one inner double-pancake coil.

8. The magnet (**1**) of claim 7, wherein the double-pancake coils (**40_{H}**,**40_{L}**) have a same height as a neighboring double-pancake coil.

9. The magnet (**1**) of any one of claims 1-8, wherein the superconducting material comprises a rare earth barium copper oxide (REBCO) superconducting material or a or bismuth strontium calcium copper oxide (BSCCO) superconducting material.

10. The magnet (**1**) of any one of claims 1-8, wherein the superconducting material comprises a high temperature superconductor (HTS).

11. A magnet (**1**) for a magnetic resonance imaging (MRI) device (**2**), the magnet comprising:
a first set of annular coils (**40, 41, 42**) comprising a superconducting material, the first set of annular coils being electrically connected together and arranged with a common coil axis (**CA**) to form a first annular magnet coil (**12**); and
a second set of annular coils comprising the superconducting material, the second set of annular coils being electrically connected together and arranged with the common coil axis (**CA**) to form a second annular magnet coil (**14**);
wherein the first annular magnet coil has an outer annular surface which is convex in a virtual plane (**P**) containing the common coil axis; and
wherein the second annular magnet coil has an outer annular surface which is convex in the virtual plane containing the common coil axis.

12. The magnet (**1**) of claim 11, wherein:
the first annular magnet coil (**12**) has an inner annular surface which is planar or concave in the virtual plane (**P**) containing the common coil axis (**CA**); and
the second annular magnet coil (**14**) has an inner annular surface which is planar or concave in the virtual plane containing the common coil axis.

13. The magnet (**1**) of either one of claims 11 and 12, wherein:
a third set of annular coils (**40, 41, 42**) comprising the superconducting material, the third set of annular coils being electrically connected together and arranged with the common coil axis (**CA**) to form a first annular shield coil (**16**); and
a fourth set of annular coils comprising the superconducting material, the fourth set of annular coils being electrically connected together and arranged with the common coil axis to form a second annular shield coil (**18**);
wherein the third annular shield coil has an inner annular surface which is concave in the virtual plane (**P**) containing the common coil axis; and
wherein the fourth annular shield coil has an inner annular surface which is concave in the virtual plane containing the common coil axis.

14. The magnet (**1**) of any one of claims 11-13, wherein each annular coil (**12, 14, 16, 18, 19**) is a double-pancake coil.

15. The magnet (**1**) of claim 14, wherein each double-pancake coil comprises one or more loops (**40, 41, 42**) of tape conductor comprising the superconducting material.
